# EUROPÄISCHE PATENTSCHRIFT

(11) **EP 1 425 765 B1**
(45) Veröffentlichungstag und Bekanntmachung des Hinweises auf die Patenterteilung: **28.02.2007**
(21) Anmeldenummer: 02754938.5
(22) Anmeldetag: 25.07.2002
(51) Int. Cl.: H01F 17/00, H01L 23/64

(54) **MAGNETISCHES BAUELEMENT**
MAGNETIC COMPONENT
COMPOSANT MAGNETIQUE

(30) Priorität: 10.09.2001 DE 10144380
(43) Veröffentlichungstag der Anmeldung: 09.06.2004
(73) Patentinhaber: Infineon Technologies AG, 81669 München (DE)
(72) Erfinder: AHRENS, Carsten, 81927 München (DE); BARTL, Ulf, 81539 München (DE); HARTUNG, Wolfgang, 81541 München (DE); LOSEHAND, Reinhard, 80637 München (DE); WERTHMANN, Hubert, 81247 München (DE)
(74) Vertreter: Zimmermann & Partner
(86) Internationale Anmeldenummer: PCT/EP2002/008295
(87) Internationale Veröffentlichungsnummer: WO 2003/023795

(56) Entgegenhaltungen:
- EP-A- 0 725 407
- US-A- 6 103 405
- NOSE M ET AL: "DOMAIN STRUCTURES AND HIGH-FREQUENCY RESPONSE OF MAGNETIZATION FOR CONBZR STRIPE FILMS" IEEE TRANSLATION JOURNAL ON MAGNETICS IN JAPAN, IEEE INC, NEW YORK, US, Bd. 9, Nr. 1, 1994, Seiten 59-66, XP000484258 ISSN: 0882-4959
- PATENT ABSTRACTS OF JAPAN vol. 006, no. 200 (E-135), 9. Oktober 1982 (1982-10-09) & JP 57 111006 A (SONY KK), 10. Juli 1982 (1982-07-10)
- INOUE T ET AL: "THE EFFECT OF MAGNETIC FILM STRUCTURE ON THE INDUCTANCE OF A PLANAR INDUCTOR" IEEE TRANSACTIONS ON MAGNETICS, IEEE INC. NEW YORK, US, Bd. 34, Nr. 4, PART 1, Juli 1998 (1998-07), Seiten 1372-1374, XP000833113 ISSN: 0018-9464 in der Anmeldung erwähnt

## Beschreibung

Die vorliegende Erfindung betrifft ein magnetisches Bauelement. Die vorliegende Erfindung betrifft insbesondere ein magnetisches Bauelement, das mit anderen Bauelementen auf einem Substrat integriert ist, beispielsweise eine integrierte Induktivität oder einen integrierten Transformator.

Passive magnetische Bauelemente, wie beispielsweise Spulen oder Transformatoren, werden für eine Vielzahl von Anwendungen benötigt. So werden in einem Mobilfunktelefon derzeit bis zu 300 passive Bauelemente verarbeitet, wobei wesentliche Funktionen von magnetischen Bauelementen erfüllt werden. Jede Funktionserweiterung, sei es Dual-Band- oder Dual-Mode-Erweiterung, lässt diese Zahl weiter ansteigen. Die Montage, das Verlöten und das Testen der immer kleiner werdenden Einzelbauelemente verursachen dabei einen wesentlich Teil der Kosten für die Gerätehersteller. Dabei werden Spulen bzw. Induktoren bislang häufig in einer Dickfilmtechnik auf Keramiksubstraten oder als Luftwicklungen hergestellt. Diese Spulen haben zwar hohe Güten, sind jedoch relativ teuer. Dabei wird die Güte Q einer Spule aus dem Verhältnis ihrer Induktivität L zu ihrem Widerstand R berechnet. Es gilt Q = ωL/R, wobei ω = 2πf und der Wert von Q üblicherweise bei einer Frequenz f = 1 GHz bestimmt wird.

Um die Herstellungskosten zu senken, ist es das Ziel vieler Entwicklungen eine Vielzahl passiver Bauelemente, beispielsweise Filter, Passivnetzwerke, HF-Drossel, und insbesondere magnetische Bauelemente auf einem Chip zu integrieren. Integrierte Induktoren werden derzeit fast ausschließlich durch planare Spiralspulen realisiert, die üblicherweise auf der obersten Metallisierungsebene angeordnet sind. In der Regel bestehen die Spulen aus Metall (z.B. Al, AlSiCu, Cu), wodurch sie einen relativ niedrigen Leitungswiderstand aufweisen. Dadurch ist es möglich, integrierte Induktoren herzustellen, die eine Güte von bis zu etwa 15 bei einer Frequenz von 1 GHz erreichen. Derartige Spiralspulen sind beispielsweise in den Dokumenten J. A. Power et al., "An investigation of On Chip Spiral induktor on 0.6 µm BiCMOS technology for Appliccation", 1999 IEEE Int. Conf. on Microelectronic Test Structures, Vol. 12, Irland 1999, Seite 18-23 und A. Gromov et al., "A Model of Impedance of Planar RF Induktors Based on Magnetic Films", IEEE Transactions On Magnetics, Vol. 34, No.4, Juli 1998, Seite 1246-48 gezeigt.

Leider weisen derartige Spiralspulen auch viele Nachteile auf, die bisher höhere Güten verhinderten. Eine Spiralspule basiert auf Leitungsringen, die bei zunehmender Windungszahl die Leitung in den Innenraum der vom ersten Ring umschlossenen Fläche führen. Die gemeinsam umschlossene Flussfläche A aller Windungen und die damit verbundene Flussverkettung wird somit zunehmend verkleinert. Um dies auszugleichen, muss die Gesamtausdehnung der Spiralspule entsprechend vergrößert werden, wodurch zusätzliche Chipfläche benötigt wird. Darüber hinaus verursacht der magnetische Teilfluss, der die elektrischen Leiter durchströmt, Wirbelströme im Leitungsmaterial, was wiederum zusätzliche Verluste zur Folge hat.

Das Hauptproblem der planaren Spiralspulen liegt jedoch in der Richtung des magnetischen Flusses, da dieser, bedingt durch die Ausrichtung der Spiralspulen, zwangsläufig zu einem großen Teil durch das Substrat geführt wird. Je nach Substratleitwert treten dort ebenfalls parasitäre Wirbelstromeffekte auf, deren ohmsche Verluste die Spulengüte herabsetzen. Die genannten Effekte führen dazu, daß integrierte Spiralspulen auf leitfähigen Substraten (ρ < 20 Ωcm) nur relativ kleine Güten (Q < 15) besitzen. Trotz großer Anstrengungen der Bauelementehersteller ist es bislang nicht gelungen, integrierte Spiralspulen mit einer Güte von mehr als 15 für die Serienproduktion zu entwickeln.

Zur Erhöhung der Güte von Induktoren wurde daher die Verwendung von ferromagnetischen Materialien mit großen Permeabilitäten vorgeschlagen. So sind beispielsweise in dem Dokument M. Yamaguchi et al., "Characteristics and Analysis of thin Film Inductor with closed magnetic Circuit Strukture", IEEE Transactions On Magnetics, Vol. 28, No.5, Tohoku University in Japan, September 1992, Seite 3015-17 Experimente mit Permalloy zur Einbettung von Planarspulenleitungen offenbart. Zwischen zwei Permalloy-Schichten wurden die Planarspulen auf ein Glassubstrat integriert. Ähnliche Spulenkonzepte sind auch in dem Dokumenten T. Inoue et al., "The Effect of Magnetic Film Strukture on the Inductance of a Planar Inductor", IEEE Transactions On Magnetics, Vol. 34, No.4, Japan, Juli 1998, Seite 1372-74 und JP 06-084639 offenbart.

Da bei all diesen Spulenkonzepten das magnetische Feld H senkrecht zur magnetischen Schicht steht, ist die Führung des magnetischen Flusses jedoch sehr ineffektiv. Darüber hinaus ist ein geschlossener magnetischer Fluss technologisch nur sehr schwer zu realisieren und Luftspalte zwischen den Schichten setzen die effektive Permeabilität des Flusskreises herab.

Um die Eigenschaften von ferromagnetische Materialien effektiver einsetzen zu können, wurde weiterhin der Einsatz von Stabspulen (Solenoiden) oder Ringspulen (Toroiden) mit ferromagnetischen Kernen vorgeschlagen. Derartige integrierte Induktoren sind beispielsweise in den Dokumenten EP 0 725 407, US 5,279,988, US 5,998,048 und US 6,008,102 sowie in der Diplomarbeit Ulrich von Knobloch, "Herstellung und Charakterisierung von integrierten Hochfrequenzspulen mit magnetischem Kern", Institut für Halbleitertechnologie und Werkstoffe der Elektrotechnik der Universität Hannover offenbart.

Dabei hat sich leider herausgestellt, daß bei den vorgeschlagenen Stabspulen mit ferromagnetischen Kernen sich zwar die Güten der Spulen erhöhen lassen, die Erhöhung der Güte jedoch in der Regel nicht ausreicht, um den ebenfalls erhöhten Produktionsaufwand für die Herstellung der ferromagnetischen Kerne zu rechtfertigen. Der vorliegenden Erfindung liegt daher die Aufgabe zugrunde, ein magnetisches Bauelement bereitzustellen, das gegenüber den bisherigen magnetischen Bauelementen eine deutlich verbesserte Parametern, insbesondere eine deutlich verbesserte Güte aufweist.

Diese Aufgabe wird von dem magnetischen Bauelement gemäß dem unabhängigen Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein magnetisches Bauelement bereitgestellt, das auf einem Substrat integriert ist und das die folgenden Merkmale umfaßt:
- zumindest einen ersten elektrischen Leiter, der zumindest eine Windung aufweist,
- zumindest einen ersten magnetischen Leiter aus zumindest einer ersten Schicht magnetischen Materials, wobei die Domänen des magnetischen Materials entlang einer ersten Richtung ausgerichtet sind und die Windung des ersten elektrischen Leiters den ersten magnetischen Leiter umschließt, und
- zumindest einen zweiten magnetischen Leiter aus zumindest einer zweiten, von der ersten Schicht unterschiedlichen Schicht magnetischen Materials, wobei die Domänen des magnetischen Materials entlang einer zweiten Richtung ausgerichtet sind und der erste und der zweite magnetische Leiter hintereinander in einem magnetischen Kreis angeordnet sind, so daß
- ein magnetisches Feld, das vom einem Strom in dem ersten elektrischen Leiter erzeugt wird, in den magnetischen Leitern geführt wird und das magnetische Feld im ersten magnetischen Leiter im wesentlichen senkrecht zu der ersten Richtung und im zweiten magnetischen Leiter im wesentlichen senkrecht zu der zweiten Richtung ausgerichtet ist.

Das erfindungsgemäße magnetische Bauelement nutzt zumindest zwei unterschiedliche Schichten bzw. Schichtfolgen aus magnetischem Material zur Leitung und Verstärkung des magnetischen Flusses, d.h. die erste und die zweite Schicht werden in unterschiedlichen Schichterzeugungsprozessen bzw. Prozessschritten erzeugt. Durch die Verwendung von zwei unterschiedlichen Schichten, welche jedoch die gleiche Materialzusammensetzung aufweisen können, kann mit den magnetischen Leitern ein magnetischer Kreis mit lokal angepaßter Domänenausrichtung aufgebaut werden. Dementsprechen läßt sich mit dem erfindungsgemäßen magnetischen Bauelement deutliche Verbesserugen der Bauelementparameter, insbesondere eine deutliche Erhöhung der Güte erzielen. Dabei braucht der magnetische Kreis aus den magnetischen Leitern nicht notwendigerweise geschlossen sein. Weiterhin müssen die erste Richtung, in welche die Domänen der ersten Schicht ausgerichtet sind, und die zweite Richtung, in welche die Domänen der zweiten Schicht ausgerichtet sind, nicht notwendiger verschieden sein.

Die magnetische Bereichsstruktur von Schichten beispielsweise aus ferromagnetischen Materialien ist durch die Existenz von Domänen ("Weissche Bezirke") gekennzeichnet: Lokal ist das Schichtmaterial auf Grund der ferromagnetischen Kopplung der Elementardipole stets in Sättigung magnetisiert. Räumliche Bereiche innerhalb des Schichtmaterials, die sich in Sättigung befinden, werden als Domänen bezeichnet. Globale Magnetisierungszustände der Schicht werden durch unterschiedliche Domänenanordnungen realisiert. Zwischen den Domänen stehen als Abgrenzung die Domänenwände. In ihnen findet eine kontinuierliche Drehung der Magnetisierungsrichtung von der Vorzugsrichtung einer Domäne zu der Vorzugsrichtung der benachbarten Domäne statt.

Beim Anlegen eines Magnetfeldes an eine Domänenstruktur können unterschiedliche Prozesse ablaufen. Diese hängen wesentlich davon ab, in welcher Richtung das äußere Feld auf die vorhandenen Domänen wirkt. Wird ein Magnetfeld parallel zu der Ausrichtung der Domänen angelegt (sogenannte "leichte Richtung"), kommt es zu Domänenwandverschiebungen: Domänen mit einer Magnetisierung in Richtung des magnetischen Feldes wachsen auf Kosten von Domänen mit einer Magnetisierung, die dem magnetischen Feld entgegegengesetzt ist. Dieser Ummagnetisierungsprozess liefert eine Permeabilität µᵣ von etwa 10⁵ bis 10⁶. Er ist jedoch nur auf Wechselfelder bis zu einer Frequenz von 10 MHz beschränkt. Bei hochfrequenten Wechselfeldern führt die relativ hohe Trägheit der Domänenwände dazu, dass das magnetische Material dem äußeren Feld nicht mehr folgen kann. Die Permeabilität des Materials sinkt auf einen Wert µᵣ von etwa 1 ab.

Eine andere Form der Ummagnetisierung findet in dem Fall statt, daß das Magnetfeld senkrecht zu der Ausrichtung der Domänen angelegt wird (sogenannte "harte Richtung"). Es kommt in diesem Fall zu einer Drehung der Magnetisierung innerhalb der Domänen. Die Magnetisierung wird reversibel aus der ursprünglichen Vorzugsrichtung herausgedreht, um dem anliegenden Magnetfeld zu folgen. Dieser Ummagnetisierungsprozess liefert je nach verwendetem Material auch bei hohen Frequenzen in einem Bereich zwischen 500 MHz und 10 GHz eine Permeabilität µᵣ von etwa 10 bis 1000 (z.B. Co-Zr-N-B: µᵣ = 200 bei f < 1GHz, Co-Fe: µᵣ = 30 bei f < 8GHz). Für Anwendungen mit einer Frequenz von mehr als 10 MHz ist daher bevorzugt, wenn das magnetische Feld im wesentlichen senkrecht zu der Ausrichtung der Domänen angelegt wird.

Bei den bisher vorgeschlagenen, integrierten Spulen, die im wesentlichen nur auf einer einzigen magnetischen Schicht beruhen, traten in den magnetischen Kreisen immer wieder Abschnitte auf, in denen das Magnetfeld parallel zu den Domänen orientiert war. Diese Abschnitte des magnetischen Kreises trugen somit bei hohen Frequenzen nichts zu einer Verstärkung des magnetischen Feldes bei, obwohl die Abschnitte aus magnetischen Material bestanden. Das magnetische Baulelement gemäß der vorliegenden Erfindung vermeidet derartige Abschnitte, indem zumindest zwei magnetische Leiter aus zwei unterschiedlichen Schichten verwendet werden. Dementsprechend kann die Ausrichtung der Domänen in den Schichten und/oder die räumliche Anordnung der Schichten zueinander so gewählt, daß Abschnitte, in denen das Magnetfeld parallel zu den Domänen orientiert ist, weitgehend vermieden werden können. Dies führt zu einer deutlich effektiveren Nutzung des magnetischen Materials, was sich wiederum in deutlich verbesserten Parametern des magnetischen Bauelements niederschlägt.

Weiterhin wird der magnetische Fluß vom Substrat und von der Wicklung ferngehalten, wodurch die Wirbelstromverluste an diesen Stellen minimiert werden. Dementsprechend kann das erfindungsgemäße magnetische Bauelement auch auf leitfähigen Substraten ausgebildet werden. Da die Induktivität beispielsweise einer Spule im wesentlichen direkt proportional zur Permeabilität µᵣ des Kernmaterials ist, hängt auch die Güte der Spule direkt von der Permeabilität µᵣ des Kernmaterials ab. Mit einer großen Permeabilität µᵣ können deutlich kleinere Spulen hergestellt werden. Die daraus resultierende Verkleinerung der elektrischen Leitungslänge führt durch die geringeren ohmschen Verluste zu einer Verbesserung der Güte.

Gemäß einer bevorzugten Ausführungsform des erfindungsgemäßen magnetischen Bauelements ist zumindest einer der magnetischen Leiter geschlitzt. Weiterhin ist es bevorzugt, wenn zumindest einer der magnetischen Leiter ein Laminat aus magnetischen Schichten und elektrisch isolierenden Schichten ist. Durch eine Schlitzung und/oder Laminierung des magnetischen Materials können Wirbelstromverluste in dem magnetischen Material weitgehend vermieden werden.

Gemäß einer weiteren bevorzugten Ausführungsform des erfindungsgemäßen magnetischen Bauelements ist das magnetische Material ein weichmagnetisches Material.

Gemäß einer weiteren bevorzugten Ausführungsform des erfindungsgemäßen magnetischen Bauelements sind der erste und der zweite magnetische Leiter in unterschiedlichen Ebenen angeordnet. In diesem Fall ist der magnetische Fluß nicht auf die Ebene der ersten Schicht magnetischen Materials beschränkt und man erhält einen deutlich erhöhten Spielraum hinsichtlich des Designs des magnetischen Bauelements. Weiterhin kann in diesem Fall die zweite Richtung, in welche die Domänen der zweiten Schicht ausgerichtet sind, mit der ersten Richtung, in welche die Domänen der ersten Schicht ausgerichtet sind, übereinstimmen. Weiterhin ist es bevorzugt, wenn der erste und der zweite magnetische Leiter einen geschlossenen magnetischen Kreis bilden.

Gemäß einer weiteren bevorzugten Ausführungsform des erfindungsgemäßen magnetischen Bauelements ist der elektrische Leiter aus Kupfer gebildet. Weiterhin ist es bevorzugt, wenn der elektrische Leiter in zwei Metallisierungsebenen ausgebildet ist, die über Vias verbunden sind. Dabei ist es insbesondere bevorzugt, wenn in der ersten Schicht magnetischen Materials Kontaktlöcher vorgesehen sind, durch welche die Vias geführt werden. Durch die entsprechend großen Randbereiche des magnetischen Leiters kann ein Vordringen von Randdomänen in die magnetisch aktiven Bereiche des magnetischen Leiters verhindert werden.

Gemäß einer weiteren bevorzugten Ausführungsform des erfindungsgemäßen magnetischen Bauelements ist ein zweiter elektrischer Leiter mit zumindest einer Windung vorgesehen, wobei der zweite magnetische Leiter innerhalb der Windung des zweiten elektrischen Leiters angeordnet ist. Durch eine entsprechende Beschaltung des ersten und des zweiten elektrischen Leiters läßt sich somit entweder ein Transformator oder eine Spule mit erhöhter Induktivität herstellen. Wird ein derartiges magnetisches Bauelement als Spule eingesetzt, so ist es bevorzugt, wenn der erste elektrische Leiter und der erste magnetische Leiter zusammen eine erste Stabspule sowie der zweite elektrische Leiter und der zweite magnetische Leiter zusammen eine zweite Stabspule bilden, wobei die beiden Stabspulen in Serie geschaltet und entgegengesetzt gepolt sind.

Die Erfindung wird nachfolgend anhand von Figuren der Zeichnung näher dargestellt. Es zeigen:
- Fig. 1: eine erste Ausführungsform des erfindungsgemäßen magnetischen Bauelements,
- Fig. 2: eine weitere Querschnittsansicht der erste Ausführungsform des erfindungsgemäßen magnetischen Bauelements,
- Fig. 3: eine weitere Ausführungsform des erfindungsgemäßen magnetischen Bauelements,
- Fig. 4: eine weitere Ausführungsform des erfindungsgemäßen magnetischen Bauelements,
- Fig. 5: eine weitere Ausführungsform des erfindungsgemäßen magnetischen Bauelements, und
- Fig. 6: eine weitere Ausführungsform des erfindungsgemäßen magnetischen Bauelements.

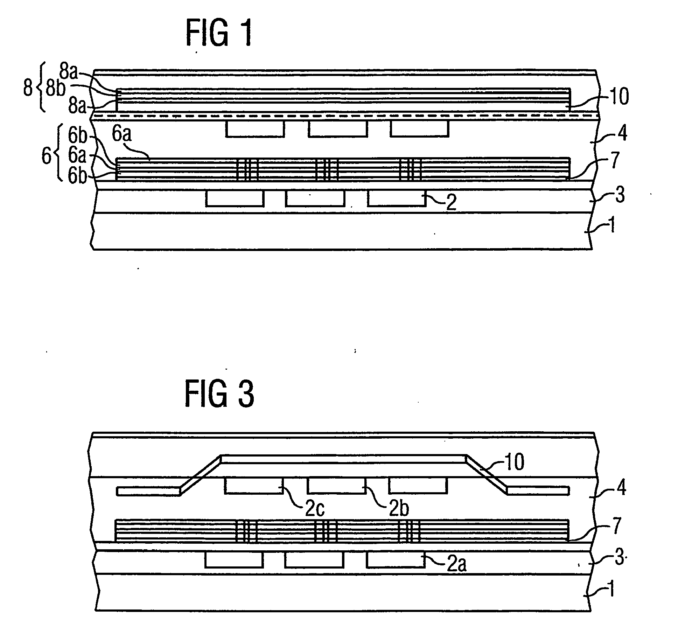

Fig. 1 zeigt eine erste Ausführungsform des erfindungsgemäßen magnetischen Bauelements. Dabei bildet in dieser Ausführungsform das erfindungsgemäße magnetische Baulement eine integrierte Spule. Das erfindungsgemäße magnetische Baulement umfaßt einem ersten elektrischen Leiter 2, der eine Vielzahl von Windungen aufweist. Zur Verringerung des elektrischen Widerstands ist der elektrische Leiter 2 aus Kupfer gebildet und er erstreckt sich über zwei Metallisierungsebenen 3 und 4, die über Vias 5 verbunden sind.

Zwischen den Metallisierungsebenen 3 und 4 ist eine erste Schichtfolge 6 von magnetischen Schichten 6a und elektrisch isolierenden Schichten 6b angeordnet. Diese Schichtfolge bildet einen ersten magnetischen Leiter 7, wobei die Windungen des elektrischen Leiter 2 den ersten magnetischen Leiter 7 umschließen. Dabei bestehen die magnetischen Schichten 6a bevorzugt aus einem weichmagnetischen Material, wie Permalloy, dessen Domänen entlang einer ersten Richtung senkrecht zur Zeichenebene ausgerichtet sind. Die elektrisch isolierenden Schichten 6b sind beispielsweise aus Siliziumoxid hergestellt.

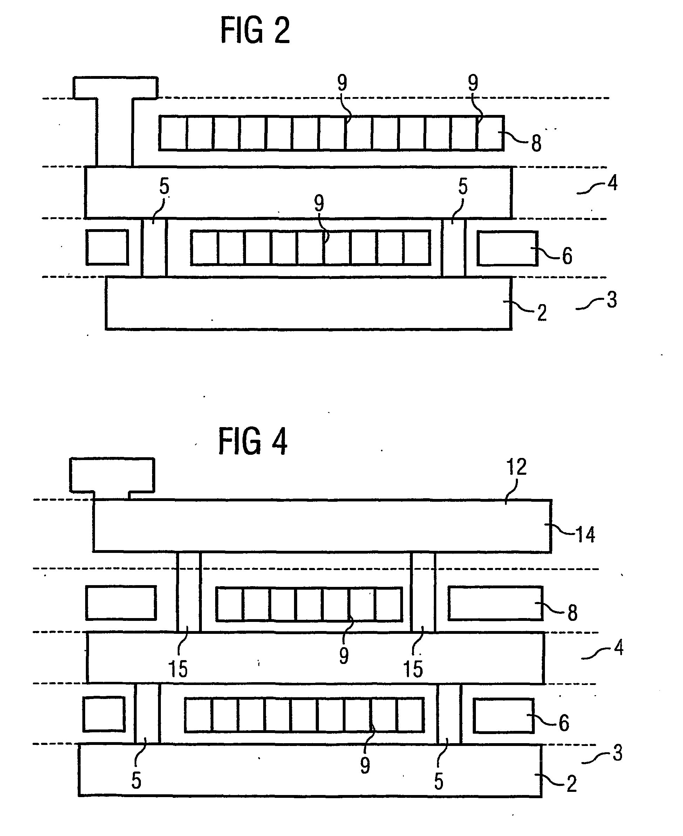

Wie aus Fig. 2 ersichtlich, weist der magnetische Leiter 7 zusätzlich zu der Laminatstruktur (in Fig. 2 nicht gezeigt) eine Vielzahl von Schlitzungen 9 auf, die wiederum mit Siliziumoxid gefüllt sind. Durch die Schlitzung und die Laminierung des magnetischen Materials können Wirbelstromverluste in dem magnetischen Material weitgehend vermieden werden. Weiterhin sind in der ersten Schichtfolge 6 Kontaktlöcher vorgesehen sind, durch welche die Vias 5 geführt werden. Durch die entsprechend großen Randbereiche des magnetischen Materials kann ein Vordringen von Randdomänen in die magnetisch aktiven Bereiche des magnetischen Leiters 7 verhindert werden.

Über der oberen Metallisierungsebene 4 ist eine zweite Schichtfolge 8 von magnetischen Schichten 8a und elektrisch isolierenden Schichten 8b angeordnet. Diese zweite Schichtfolge 8 bildet einen zweiten magnetischen Leiter 10. Dabei bestehen die magnetischen Schichten 8a ebenfalls aus einem weichmagnetischen Material, wie Permalloy, dessen Domänen wiederum entlang der Richtung senkrecht zur Zeichenebene ausgerichtet sind. Die elektrisch isolierenden Schichten 8b sind ebenfalls aus Siliziumoxid hergestellt. An der Seite der Schichtfolge sind weiterhin Kontakte zur dem elektrischen Leiter 2 vorgesehen (Fig. 2).

Der erste magnetische Leiter 7 und der zweite magnetische Leiter 10 bilden die wesentlichen Bestandteile eines magnetischen Kreises, der über das isolierende Material zwischen den äußeren Bereichen der magnetischen Leiter 7 und 10 geschlossen wird. Die räumliche Anordnung der Schichtfolgen 6 und 8 sowie die Ausrichtung der Domänen in den Schichtfolgen hat zur Folge, daß ein magnetisches Feld, das vom einem Strom in dem ersten elektrischen Leiter 2 erzeugt und in den magnetischen Leitern 7 und 10 geführt wird, in beiden magnetischen Leitern 7 und 10 jeweils senkrecht zu der Ausrichtung der Domänen ausgerichtet ist. Es kommt somit zu einer Drehung der Magnetisierung innerhalb der Domänen. Die Magnetisierung wird reversibel aus der ursprünglichen Vorzugsrichtung herausgedreht, um dem anliegenden Magnetfeld zu folgen. Dieser Ummagnetisierungsprozess liefert je nach verwendetem Material auch bei hohen Frequenzen in einem Bereich zwischen 500 MHz und 10 GHz eine Permeabilität µᵣ von etwa 10 bis 1000.

Fig. 3 zeigt eine weitere Ausführungsform des erfindungsgemäßen magnetischen Bauelements. Die in Fig. 3 gezeigte Ausführungsform entspricht im wesentlichen der in Fig. 1 gezeigten Ausführung mit dem Unterschied, daß bedingt durch eine entsprechende Ausgestaltung des zweiten magnetischen Leiters 10 ein geschlossener magnetischer Kreis entsteht, der sich nur aus den magnetischen Leitern 7 und 10 zusammensetzt .

Fig. 4 zeigt eine weitere Ausführungsform des erfindungsgemäßen magnetischen Bauelements. Im Gegensatz zu den bisher gezeigten Ausführungsformen weist die in Fig. 4 gezeigte Auführungsform einen zweiten elektrischen Leiter 12 auf, dessen Windungen den zweiten magnetischen Leiter 10 umschließen und der sich über die Metallisierungsebene 4 und eine weitere Metallisierungsebene 14 erstreckt. Die Metallisierungsebenen 4 und 14 sind wiederum über Vias 15 miteinander elektrisch leitend verbunden.

Durch eine entsprechende Beschaltung des ersten und des zweiten elektrischen Leiters 12 läßt sich somit entweder ein Transformator oder eine Spule mit erhöhter Induktivität herstellen. Wird ein derartiges magnetisches Bauelement als Spule eingesetzt, so ist es bevorzugt, wenn der erste elektrische Leiter 2 und der erste magnetische Leiter 7 zusammen eine erste Stabspule sowie der zweite elektrische Leiter 12 und der zweite magnetische Leiter 10 zusammen eine zweite Stabspule bilden, wobei die beiden Stabspulen in Serie geschaltet und entgegengesetzt gepolt sind.

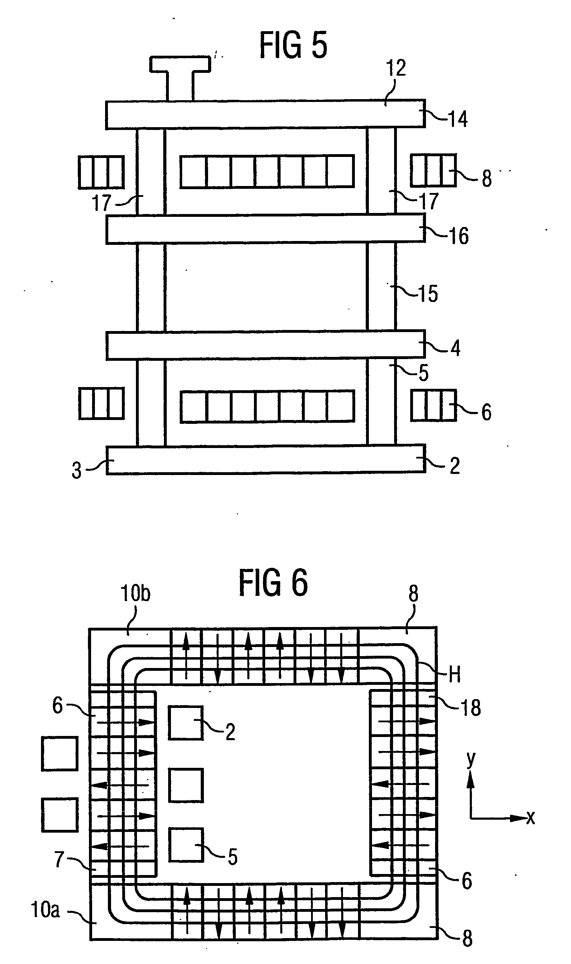

Fig. 5 zeigt eine weitere Ausführungsform des erfindungsgemäßen magnetischen Bauelements. Wie die in Fig. 4 gezeigte Ausführungsform weist die in Fig. 5 gezeigte Auführungsform einen zweiten elektrischen Leiter 12 auf, dessen Windungen den zweiten magnetischen Leiter 10 umschließen. Im Gegensatz zu der in Fig. 4 gezeigte Ausführungsform ist bei der in Fig. 5 gezeigte Auführungsform eine zusätzliche Metallisierungsebene 16 vorgesehen, so daß sich der zweiten elektrischen Leiter 12 über die Metallisierungsebene 14 und die zusätzliche Metallisierungsebene 16 erstreckt. Die Metallisierungsebenen 14 und 16 sind wiederum über Vias 17 miteinander elektrisch leitend verbunden.

Fig. 6 zeigt eine weitere Ausführungsform des erfindungsgemäßen magnetischen Bauelements. Im Gegensatz zu den bisher gezeigten Ausführungsformen ist bei der in Fig. 6 gezeigte Auführungsform das magnetische Bauelement nur in einer Ebene angeordnet und Fig. 6 zeigt eine Aufsicht auf diese Ebene. Das erfindungsgemäße magnetische Baulement umfaßt einem ersten elektrischen Leiter 2, der eine Vielzahl von Windungen aufweist. Zur Verringerung des elektrischen Widerstands ist der elektrische Leiter 2 aus Kupfer gebildet und er erstreckt sich über zwei Metallisierungsebenen (nicht gezeigt), die über Vias 5 verbunden sind.

Die Windungen des elektrischen Leiter 2 umschließen den ersten magnetischen Leiter 7, der aus einer ersten Schichtfolge 6 von magnetischen Schichten und elektrisch isolierenden Schichten gebildet ist. Das in Fig. 6 gezeigte, magnetische Bauelement weist darüber hinaus einen weiteren magnetischen Leiter 18, der ebenfalls aus der ersten Schichtfolge 6 gebildet ist. Weiterhin weist das in Fig. 6 gezeigte, magnetische Bauelement die magnetischen Leiter 10a und 10b auf, die aus einer zweiten Schichtfolge 8 von magnetischen Schichten und elektrisch isolierenden Schichten gebildet sind.

Wiederum weisen die magnetischen Leiter 7, 10a, 10b und 18 zusätzlich zu der Laminatstruktur eine Vielzahl von Schlitzungen (nicht gezeigt) auf, die wiederum mit einem isolierenden Material gefüllt sind. Durch die Schlitzung und die Laminierung des magnetischen Materials können Wirbelstromverluste in dem magnetischen Material weitgehend vermieden werden.

Zum besseren Verständnis der Erfindung ist in Fig. 6 zusätzlich die Domänenstruktur des magnetischen Material gezeigt. Dabei sind die Domänen aus Gründen der Übersichtlichkeit übertrieben groß dargestellt. Man erkennt, daß die Domänen der magnetischen Leiter 7 und 18, die aus der ersten Schicht 6 magnetischen Materials gebildet sind, in eine erste Richtung (x-Richtung) ausgerichtet sind. Im Gegensatz dazu sind die Domänen der magnetischen Leiter 10a und 10b, die aus der zweiten Schicht 8 magnetischen Materials gebildet sind, in eine zweite Richtung (y-Richtung) senkrecht zu der ersten Richtung (x-Richtung) ausgerichtet.

Die Fig. 6 gezeigten magnetischen Leiter mit ihren Domänenausrichtungen können beispielsweise folgende Prozeßschritte hergestellt. Auf einem Substrat, in dem bereits die untere Metallisierungsebene erzeugt wurde, wird Laskemaske erzeugt, welche an den Stellen Öffnungen aufweist, an denen beispielsweise die magnetischen Leiter 7 und 18 erzeugt werden sollen. Anschließend wird ganzflächig die erste Schichtfolge 6 magnetischen Materials beispielsweise durch Sputtern aufgebracht. Mit Hilfe einer sogenannten "Lift-Off"-Technik wird diese Schichtfolge bis auf die Schichtteile, die in den Öffnungen der Lackmaske angeordnet sind, wieder entfernt. Anschließend führt eine Wärmebehandlung in einem relativ starken Magnetfeld zum Einprägen der Fig. 6 gezeigten Domänenausrichtung der magnetischen Leiter 7 und 18.

Auf die so erzeugte Struktur wird nun wiederum eine Lackmaske aufgebracht, welche an den Stellen Öffnungen aufweist, an denen die magnetischen Leiter 10a und 10b erzeugt werden sollen. Anschließend wird durch Sputtern die zweite Schicht 8 magnetischen Materials aufgebracht. Zur Ausprägung der gewünschten Domänenausrichtung wird nun aber bereits während des Sputterprozesses ein Magnetfeld angelegt, so daß die in Fig. 6 gezeigte Domänenausrichtung der magnetischen Leiter 10a und 10b entsteht. Durch eine weiteren Lift-Off-Prozeß wird schließlich die in Fig. 6 gezeigte Struktur erzeugt.

Zusätzlich zu den Domänenausrichtungen ist in Fig. 6 das magnetisches Feld H gezeigt, das vom einem Strom in dem ersten elektrischen Leiter 2 erzeugt wird. Man erkennt, daß das magnetische Feld in den magnetischen Leitern 7, 10a, 10b und 17 geführt wird und das magnetische Feld H in den magnetischen Leitern jeweils im wesentlichen senkrecht zu den Domänenausrichtungren ausgerichtet ist.

Im Gegensatz zu den bisher vorgeschlagenen, integrierten Spulen nach dem Stand der Technik, die im wesentlichen nur auf einer einzigen magnetischen Schicht beruhen und die dementsprechend immer wieder Abschnitte aufwiesen, in denen das Magnetfeld parallel zu den Domänen orientiert war, vermeidet das magnetische Baulelement gemäß der vorliegenden Erfindung derartige Abschnitte, indem zumindest zwei magnetische Leiter aus zwei unterschiedlichen Schichten verwendet werden. Dementsprechend kann die Ausrichtung der Domänen in den Schichten und/oder die räumliche Anordnung der Schichten zueinander so gewählt, daß Abschnitte, in denen das Magnetfeld parallel zu den Domänen orientiert ist, weitgehend vermieden werden können. Dies führt zu einer deutlich effektiveren Nutzung des magnetischen Materials, was sich wiederum in deutlich verbesserten Parametern des magnetischen Bauelements niederschlägt. Insbesondere können somit integrierten Spulen realisiert werden, die eine Güte Q ≥ 30 bzw. Q ≥ 50 aufweisen.

## Patentansprüche

1. Magnetisches Bauelement, das auf einem Substrat (1) integriert ist, mit
- zumindest einem ersten elektrischen Leiter (2), der zumindest eine Windung aufweist,
- zumindest einem ersten magnetischen Leiter (7) aus zumindest einer ersten Schicht (6a) magnetischen Materials , wobei die Domänen des magnetischen Materials entlang einer ersten Richtung ausgerichtet sind und die Windung des ersten elektrischen Leiters (2) den ersten magnetischen Leiter (7) umschließt, und
- zumindest einem zweiten magnetischen Leiter (10, 10a, 10b) aus zumindest einer zweiten, von der ersten Schicht unterschiedlichen Schicht (8a) magnetischen Materials, wobei die Domänen des magnetischen Materials entlang einer zweiten Richtung ausgerichtet sind und der erste und der zweite magnetische Leiter (7, 10, 10a, 10b) hintereinander in einem magnetischen Kreis angeordnet sind, so daß
- ein magnetisches Feld, das vom einem Strom in dem ersten elektrischen Leiter (2) erzeugt wird, in den magnetischen Leitern (7, 10, 10a, 10b) geführt wird und das magnetische Feld im ersten magnetischen Leiter (7) im wesentlichen senkrecht zu der ersten Richtung und im zweiten magnetischen Leiter (10, 10a, 10b) im wesentlichen senkrecht zu der zweiten Richtung ausgerichtet ist.

2. Bauelement nach Anspruch 1,
**dadurch gekennzeichnet, daß** zumindest einer der magnetischen Leiter (7, 10, 10a, 10b) geschlitzt ist.

3. Bauelement nach Anspruch 1 oder 2,
**dadurch gekennzeichnet, daß**
zumindest einer der magnetischen Leiter eine Schichtfolge 6, 8) aus magnetischen Schichten (6a, 8a) und elektrisch isolierenden Schichten (6b, 8b) ist.

4. Bauelement nach einem der vorhergehenden Ansprüchen,
**dadurch gekennzeichnet, daß**
das magnetische Material ein weichmagnetisches Material ist.

5. Bauelement nach einem der vorhergehenden Ansprüchen,
**dadurch gekennzeichnet, daß**
der erste und der zweite magnetische Leiter (7, 10) in unterschiedlichen Ebenen angeordnet sind.

6. Bauelement nach einem der vorhergehenden Ansprüchen,
**dadurch gekennzeichnet, daß**
der erste und der zweite magnetische Leiter (7, 10) einen geschlossenen magnetischen Kreis bilden.

7. Bauelement nach einem der vorhergehenden Ansprüchen,
**dadurch gekennzeichnet, daß**
der elektrische Leiter (2) aus Kupfer gebildet ist.

8. Bauelement nach einem der vorhergehenden Ansprüchen,
**dadurch gekennzeichnet, daß**
der elektrische Leiter (2) in zwei Metallisierungsebenen (3, 4) ausgebildet ist, die über Vias (5) verbunden sind.

9. Bauelement nach Anspruch 8,
**dadurch gekennzeichnet, daß**
in der ersten Schicht (6a) magnetischen Materials Kontaktlöcher vorgesehen sind, durch welche die Vias (5) geführt werden.

10. Bauelement nach einem der vorhergehenden Ansprüchen,
**dadurch gekennzeichnet, daß**
ein zweiter elektrischer Leiter (12) mit zumindest einer Windung vorgesehen ist, wobei die Windung des zweiten elektrischen Leiters (12) den zweiten magnetischen Leiter (10) umschließt.

11. Bauelement nach Anspruch 10,
**dadurch gekennzeichnet, daß**
das magnetische Bauelement als Transformator ausgebildet ist.

12. Bauelement nach Anspruch 10,
**dadurch gekennzeichnet, daß**
das magnetische Bauelement als Induktivität mit zwei entgegengesetzt gepolten Spulen ausgebildet ist.

## Claims

1. Magnetic component which is integrated on a substrate (1), having
- at least one first electrical conductor (2) which has at least one turn,
- at least one first magnetic conductor (7) composed of at least one first layer (6a) of magnetic material, with the domains of the magnetic material being aligned along a first direction, and the turn of the first electrical conductor (2) surrounding the first magnetic conductor (7), and
- at least one second magnetic conductor (10, 10a, 10b) composed of at least one second layer (8a), which is different to the first layer, of magnetic material, with the domains of the magnetic material being aligned along a second direction, and the first and the second magnetic conductors (7, 10, 10a, 10b) being arranged one behind the other in a magnetic circuit, such that
- a magnetic field which is produced by a current in the first electrical conductor (2) is carried in the magnetic conductors (7, 10, 10a, 10b), and the magnetic field in the first magnetic conductor (7) is aligned essentially at right angles to the first direction, and in the second magnetic conductor (10, 10a, 10b) is aligned essentially at right angles to the second direction.

2. Component according to Claim 1,
**characterized in that**
at least one of the magnetic conductors (7, 10, 10a, 10b) is slotted.

3. Component according to Claim 1 or 2,
**characterized in that**
at least one of the magnetic conductors is a layer sequence (6, 8) composed of magnetic layers (6a, 8a) and electrically insulating layers (6b, 8b).

4. Component according to one of the preceding claims,
**characterized in that**
the magnetic material is a soft-magnetic material.

5. Component according to one of the preceding claims,
**characterized in that**
the first and the second magnetic conductors (7, 10) are arranged in different planes.

6. Component according to one of the preceding claims,
**characterized in that**
the first and the second magnetic conductors (7, 10) form a closed magnetic circuit.

7. Component according to one of the preceding claims,
**characterized in that**
the electrical conductor (2) is formed from copper.

8. Component according to one of the preceding
claims, **characterized in that**
the electrical conductor (2) is in the form of two metalization planes (3, 4), which are connected by means of vias (5).

9. Component according to Claim 8,
**characterized in that**
contact holes, through which the vias (5) are passed, are provided in the first layer (6a) of magnetic material.

10. Component according to one of the preceding claims,
**characterized in that**
a second electrical conductor (12) having at least one turn is provided, with the turn of the second electrical conductor (12) surrounding the second magnetic conductor (10).

11. Component according to Claim 10,
**characterized in that**
the magnetic component is in the form of a transformer.

12. Component according to Claim 10,
**characterized in that**
the magnetic component is in the form of an inductance with two coils of opposite polarity.

## Revendications

1. Composant magnétique qui est intégré sur un substrat (1), comprenant
- au moins un premier conducteur (2) électrique qui a une moins une spire ;
- au moins un premier conducteur (7) magnétique constitué d'au moins une première couche (6a) de matériau magnétique, les domaines du matériau magnétique étant dirigés suivant une première direction et la spire du premier conducteur (2) électrique entourant le premier conducteur (7) magnétique ; et
- au moins un deuxième conducteur (10, 10a, 10b) magnétique constitué d'au moins une deuxième couche (8a) de matériau magnétique différente de la première couche, les domaines du matériau magnétique étant dirigés suivant une deuxième direction et le premier et le deuxième conducteurs (7, 10, 10a, 10b) magnétiques étant disposés l'un derrière l'autre dans un cercle magnétique, de sorte que
- il passe un champ magnétique produit par un courant dans le premier conducteur (2) électrique dans les conducteurs (7, 10, 10a, 10b) magnétiques et le champ magnétique dans le premier conducteur (7) magnétique est dirigé sensiblement perpendiculairement à la première direction et dans le deuxième conducteur (10, 10a, 10b) magnétique sensiblement perpendiculairement à la deuxième direction.

2. Composant suivant la revendication 1,
**caractérisé**
**en ce qu'**au moins l'un des conducteurs (7, 10, 10a, 10b) magnétiques est fendu.

3. Composant suivant la revendication 1 ou 2,
**caractérisé**
**en ce qu'**au moins l'un des conducteurs magnétiques est une succession (6, 8) de couches (6a, 8a) magnétiques et de couches (6b, 8b) isolantes du point de vue électrique.

4. Composant suivant l'une des revendications précédentes,
**caractérisé**
**en ce que** le matériau magnétique est un matériau magnétique doux.

5. Composant suivant l'une des revendications précédentes,
**caractérisé**
**en ce que** le premier et le deuxième conducteurs (7, 10) magnétiques sont disposés dans des plans différents.

6. Composant suivant l'une des revendications précédentes,
**caractérisé**
**en ce que** le premier et le deuxième conducteurs (7, 10) magnétiques forment un circuit magnétique fermé.

7. Composant suivant l'une des revendications précédentes,
**caractérisé**
**en ce que** le conducteur (2) électrique est en cuivre.

8. Composant suivant l'une des revendications précédentes,
**caractérisé**
**en ce que** le conducteur (2) électrique est constitué dans deux plans (3, 4) de métallisation qui sont reliés par des traversées (5).

9. Composant suivant la revendication 8,
**caractérisé**
**en ce qu'**il est prévu dans la première couche (6a) de matériau magnétique des trous de contact, par lesquels passent les traversées (5).

10. Composant suivant l'une des revendications précédentes,
**caractérisé**
**en ce qu'**il est prévu un deuxième conducteur (12) électrique ayant au moins une spire, la spire du deuxième conducteur (12) électrique entourant le deuxième conducteur (10) magnétique.

11. Composant suivant la revendication 10,
**caractérisé**
**en ce que** le composant magnétique est constitué sous la forme d'un transformateur.

12. Composant suivant la revendication 10,
**caractérisé**
**en ce que** le composant magnétique est constitué sous la forme d'une inductance ayant deux bobines de polarité opposée.
